# EUROPÄISCHE PATENTSCHRIFT

(11) **EP 0 782 765 B1**
(45) Veröffentlichungstag und Bekanntmachung des Hinweises auf die Patenterteilung: **28.06.2000**
(21) Anmeldenummer: 95934106.6
(22) Anmeldetag: 22.09.1995
(51) Int. Cl.: H01L 23/13, H01L 23/498

(54) **POLYMER STUD GRID ARRAY PACKAGE**
POLYMER STUD GRID ARRAY PACKAGE
EMBALLAGE DE MATRICE A PROJECTIONS EN POLYMERES

(30) Priorität: 23.09.1994 DE 4434086
(43) Veröffentlichungstag der Anmeldung: 09.07.1997
(60) Teilanmeldung: 99116980.6
(73) Patentinhaber: SIEMENS N.V., 1060 Bruxelles (BE); INTERUNIVERSITAIR MICRO-ELEKTRONICA CENTRUM VZW, 3001 Leuven Brabant (BE)
(72) Erfinder: HEERMAN, Marcel, B-9200 Merelbeke (BE); WILLE, Joost, B-8210 Loppem (BE); VAN PUYMBROECK, Jozef, B-8020 Oostkamp (BE); ROGGEN, Jean, B-3560 Lummen (BE); BEYNE, Eric, B-3001 Leuven (BE); VAN HOOF, Rita, B-3191 Boortmeerbeek (BE)
(74) Vertreter: Zedlitz, Peter, Dipl.-Inf.
(86) Internationale Anmeldenummer: EP9503763
(87) Internationale Veröffentlichungsnummer: WO9609646

(56) Entgegenhaltungen:
- EP-A- 0 558 325
- WO-A-89/00346
- WO-A-89/10005
- US-A- 3 271 507
- US-A- 3 483 308
- US-A- 5 081 520

## Beschreibung

Integrierte Schaltkreise bekommen immer höhere Anschlußzahlen und werden dabei immer weiter miniaturisiert. Die bei dieser zunehmenden Miniaturisierung erwarteten Schwierigkeiten mit Lotpastenauftrag und Bestückung, sollen durch neue Gehäuseformen behoben werden, wobei hier insbesondere Single- Few- oder Multi-Chip-Module im Ball Grid Array Package hervorzuheben sind (DE-Z productronic 5, 1994, Seiten 54, 55). Diese Module basieren auf einem durchkontaktierten Substrat, auf welchem die Chips beispielsweise über Kontaktierdrähte oder mittels Flipchip-Montage kontaktiert sind. An der Unterseite des Substrats befindet sich das Ball Grid Array (BGA), das häufig auch als Solder Grid Array, Land Grid Array oder Solder Bump Array, bezeichnet wird. Das Ball Grid Array umfaßt auf der Unterseite des Substrats flächig angeordnete Lothöcker, die eine Oberflächenmontage auf den Leiterplatten oder Baugruppen ermöglichen. Durch die flächige Anordnung der Lothöcker, können hohe Anschlußzahlen in einem groben Raster von beispielsweise 1,27 mm realisiert werden.

Bei der sogenannten MID Technologie (MID = Moulded Interconnection Devices), werden anstelle konventioneller gedruckter Schaltungen Spritzgießteile mit integrierten Leiterzügen verwendet. Hochwertige Thermoplaste, die sich zum Spritzgießen von dreidimensionalen Substraten eignen, sind die Basis dieser Technologie. Derartige Thermoplaste zeichnen sich gegenüber herkömmlichen Substratmaterialien für gedruckte Schaltungen durch bessere mechanische, thermische, chemische, elektrische und umwelttechnische Eigenschaften aus. Bei einer speziellen Richtung der MID Technologie, der sogenannten SIL-Technik (SIL = Spritzgießteile mit integrierten Leiterzügen), erfolgt die Strukturierung einer auf die Spritzgießteile aufgebrachten Metallschicht unter Verzicht auf die sonst übliche Maskentechnik durch ein spezielles Laserstrukturierungsverfahren. In die dreidimensionalen Spritzgießteile mit strukturierter Metallisierung sind dabei mehrere mechanische und elektrische Funktionen integrierbar. Die Gehäuseträgerfunktion übernimmt gleichzeitig Führungen und Schnappverbindungen, während die Metallisierungsschicht neben der Verdrahtungs- und Verbindungsfunktion auch als elektromagnetische Abschirmung dient und für eine gute Wärmeabfuhr sorgt. Weitere Einzelheiten zur Herstellung von dreidimensionalen Spritzgießteilen mit integrierten Leiterzügen, gehen beispielsweise aus der DE-A-37 32 249 oder der EP-A-0 361 192 hervor.

Aus der WO-A-89/00346 ist ein Single-Chip-Modul bekannt, bei welchem das spritzgegossene, dreidimensionale Substrat aus einem elektrisch isolierenden Polymer auf der Unterseite des Substrats beim Spritzgießen mitgeformte Höcker trägt, die ggf. auch flächig angeordnet sein können. Auf der Oberseite dieses Substrats ist ein IC-Chip angeordnet, dessen Anschlüsse über feine Bonddrähte mit auf der Oberseite des Substrats ausgebildeten Leiterbahnen verbunden sind. Diese Leiterbahnen sind ihrerseits über Durchkontaktierungen mit zugeordneten, auf den Höckern gebildeten Außenanschlüssen verbunden.

Aus der US-A-3 483 308 ist ein Single-Chip-Modul bekannt, bei welchem ein aus Keramik oder auch aus Kunststoff bestehendes Substrat auf seiner Unterseite zwei entgegengesetzt peripher zueinander angeordnete Reihen von integral angeformten Hökkern trägt. Auf der Oberseite dieses Substrats ist ein IC-Chip angeordnet, dessen Anschlüsse über feine Bonddrähte mit auf der Oberseite des Substrats ausgebildeten Leiterbahnen verbunden sind. Diese Leiterbahnen sind ihrerseits über Durchkontaktierungen oder über auf der Stirnseite des Substrats verlaufende Querverbindungen mit zugeordneten, auf den Höckern gebildeten Außenanschlüssen verbunden.

Aus der WO-A-89/10005 ist ein Chipgehäuse bekannt, dessen aus einem Kunststoff bestehender Trägerkörper auf seiner Unterseite mit vier randseitig angeordneten und integral angeformten Rippen versehen ist. Die eigentliche Verdrahtung besteht hier auf einer flexiblen Schaltung, die auf die Oberseite oder die Unterseite des Trägerkörpers aufgebracht und um die randseitigen Rippen gewunden wird, wobei im Scheitelbereich der Rippen entsprechende Außenanschlüsse gebildet werden. Die flexible Verdrahtung trägt einen oder mehrere IC-Chips, die dann je nach Ausführungsform auf der Oberseite oder der Unterseite des Trägerkörpers angeordnet sind.

Aus der US-A-5 081 520 ist ein Verfahren zum Befestigen von IC-Chips auf Substraten bekannt, bei welchem die Substrate als Spritzgießteile mit integrierten Höckern für die Befestigung der IC-Chips hergestellt werden. Nach dem Metallisieren der Höcker wird eine Verbindungsschicht aufgebracht, so daß die IC-Chips auf den Substraten befestigt werden können, wobei die Chip-Anschlußflächen mit den zugeordneten Metallisierungen der Höcker elektrisch leitend verbunden werden.

Der im Anspruch 1 angegebenen Erfindung liegt das Problem zugrunde, eine neue Bauform für Single-, Few- oder Multi-Chip-Module zu schaffen, welche die Vorteile der MID Technologie aufweist und eine flächige Anordnung der Außenanschlüsse, wie beim Ball Grid Array ermöglicht.

Die erfindungsgemäße Bauform ist in Anlehnung an das Ball Grid Array (BGA) Package als Polymer Stud Grid Array (PSGA) Package bezeichnet, wobei der Begriff "Polymer Stud" auf die beim Spritzgießen des Substrats mitgeformten Polymerhöcker hinweisen soll. Neben der einfachen und kostengünstigen Herstellung der Polymerhöcker beim Spritzgießen des Substrats, kann auch die Herstellung der Außenanschlüsse auf den Polymerhöckern mit minimalen Aufwand zusammen mit der bei der MID Technologie bzw. der SIL-Technik üblichen Herstellung der Leiterzüge vorgenommen werden. Durch die bei der SIL-Technik bevorzugte Laserfeinstrukturierung, können die Außenanschlüsse auf den Polymerhöckern mit hohen Anschlußzahlen in einem sehr feinen Raster realisiert werden. Hervorzuheben ist ferner, daß die Temperaturausdehnung der Polymerhöcker den Temperaturausdehnungen des Substrats und der das Modul aufnehmenden Leiterplatte entspricht. Sollten mechanische Spannungen auftreten, so ermöglichen die Polymerhöcker durch ihre elastischen Eigenschaften zumindest einen teilweisen Ausgleich. Durch die Formstabilität der auf den Polymerhöckern gebildeten Außenanschlüsse, kann auch die Sicherheit bei Reparatur und Austausch gegenüber den Ball Grid Arrays mit ihren durch Lothöcker gebildeten Außenanschlüssen erheblich gesteigert werden.

Vorteilhafte Ausgestaltungen der Erfindung sind in den Unteransprüchen angegeben.

Die Ausgestaltung nach Anspruch 2 ermöglicht eine versunkene Montage der Chips in Mulden der spritzgegossenen Substrate, wodurch eine extrem geringe Dicke der resultierenden Single-, Few- oder Multi-Chip-Module realisiert werden kann. Die versunkene Montage ermöglicht außerdem einen optimalen Schutz der Chips, sowie eine einfache und hermetisch dichte Verkapselung.

Die Weiterbildung nach Anspruch 3 ermöglicht eine Kontaktierung der Chips in der bewährten Drahtbond-Technik. Gemäß Anspruch 4 kann die Anbringung der Kontaktierdrähte durch die Anordnung der Innenanschlüsse auf einer Stufe der Mulde erleichtert werden.

Gemäß Anspruch 5 kann für die Kontaktierung der Chips auch die Flipchip-Technik mit Erfolg eingesetzt werden.

Bei der Flipchip-Kontaktierung können gemäß Anspruch 6 zur Direktverbindung der Chipanschlüsse mit den zugeordneten Innenanschlüssen die Chipanschlüsse als schmelzfähige Höcker ausgebildet sein.

Gemäß Anspruch 7 können bei der Flipchip-Kontaktierung aber auch die Innenanschlüsse durch beim Spritzgießen des Substrats mitgeformte und mit einer lötbare Endoberfläche versehene Polymerhöcker gebildet sein. Hierdurch können einerseits normale Chips ohne schmelzfähige Höcker verwendet werden, während andererseits die Herstellung und Metallisierung der Polymerhöcker bei der MID Technologie praktisch ohne zusätzlichen Aufwand durchgeführt werden kann. Die Polymerhöcker haben zusätzlich den Vorteil, daß sie einen elastischen Ausgleich zwischen unterschiedlichen Ausdehnungsverhalten von Substrat und Chip erlauben.

Ausführungsbeispiele der Erfindung sind in der Zeichnung dargestellt und werden im folgenden näher beschrieben.

Es zeigen
- Figur 1: einen Schnitt durch ein Polymer Stud Grid Array mit einem in Drahtbond-Technik kontaktierten Chip,
- Figur 2: einen Schnitt durch ein Polymer Stud Grid Array mit einem gemäß einer ersten Ausführungsform in Flipchip-Technik kontaktierten Chip,
- Figur 3: einen Schnitt durch ein Polymer Stud Grid Array mit einem gemäß einer zweiten Ausführungsform in Flipchip-Technik kontaktierten Chip,
- Figur 4: einen Schnitt durch das Substrat des in Figur 1 dargestellten Polymer Stud Grid Arrays mit einer Draufsicht auf Außenanschlüsse, Leiterzüge und Innenanschlüsse und
- Figur 5: einen vergrößerten Ausschnitt der Figur 4 mit Außenanschlüssen, Leiterzügen und Innenanschlüssen.

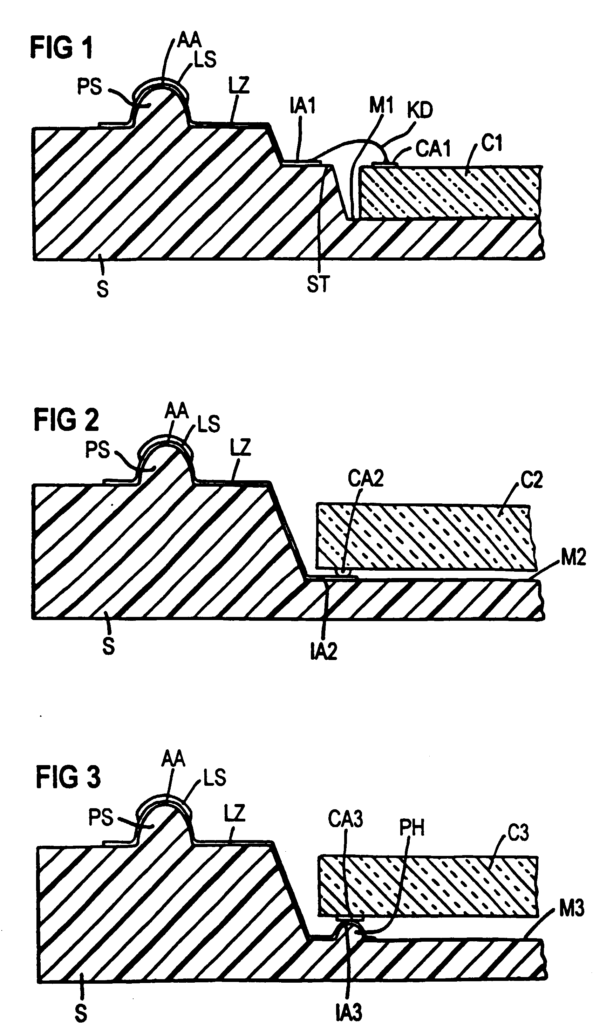

Figur 1 zeigt einen Schnitt durch einen Teil eines Polymer Stud Grid Arrays mit einem in Drahtbond-Technik kontaktierten Chip C1. Basis des dargestellten Arrays ist ein Substrat S, das mit "Polymer Studs" bzw. Polymerhöckern PS und einer Mulde M1 versehen ist, wobei die Mulde M1 eine mit ST bezeichnete Stufe aufweist. Die Herstellung des Substrats S einschließlich Polymerhöckern PS, Mulde M1 und Stufe ST, erfolgt durch Spritzgießen, wobei als Substratmaterialien hochtemperaturbeständige Thermoplaste, wie Polyetherimid, Polyethersulfon oder Liquid Cristalline Polymers geeignet sind.

Das in Figur 1 dargestellte Substrat S wird entsprechend der MID Technologie ganzflächig metallisiert und dann einem Laserstrukturierungsverfahren unterzogen, wobei als Ergebnis dieser Laserstrukturierung Außenanschlüsse AA auf den Polymerhöckern PS, Innenanschlüsse IA1 auf der Stufe ST und sich dazwischen erstreckende Leiterzüge LZ verbleiben. Die Außenanschlüsse AA sind im Kuppenbereich mit einer Lotschicht LS versehen, wobei diese Lotschicht LS beispielsweise durch eine Zinn-Blei-Legierung gebildet ist. Anstelle der Lotschicht LS, kann auch beispielsweise eine aus einer Schichtenfolge von Nickel und Gold bestehende lötbare Endoberfläche vorgesehen sein. Die auf der Stufe ST angeordneten Innenanschlüsse IA1 sind über Kontaktierdrähte KD mit den Anschlüssen CA1 des am Boden der Mulde M1 in Face up-Lage befestigten Chips C1 verbunden.

Das in Figur 1 dargestellte Polymer Stud Grid Array wird mit den auf den Polymerhöckern PS gebildeten Außenanschlüssen AA nach unten auf einer nicht dargestellten Leiterplatte oder Baugruppe kontaktiert. Entgegen der in Figur 1 dargestellten Lage, handelt es sich also bei der Seite mit den Polymerhöckern PS um die Unterseite des Substrats S.

Figur 2 zeigt einen Schnitt durch einen Teil eines Polymer Stud Grid Arrays mit einem gemäß einer ersten Ausführungsform in Flipchip-Technik kontaktierten Chip C2. Im Unterschied zu Figur 1 liegen hier die mit IA2 bezeichneten Innenanschlüsse am Boden einer mit M2 bezeichneten Mulde. Der in Face down-Lage in der Mulde M2 angeordnete Chip C2 besitzt Chipanschlüsse CA2 in Form schmelzfähiger Höcker, die auf den zugeordneten Innenanschlüssen IA2 aufliegen und mit diesen beim Löten verbunden werden.

Figur 3 zeigt einen Schnitt durch einen Teil eines Polymer Stud Grid Arrays mit einem gemäß einer zweiten Ausführungsform in Flipchip-Technik kontaktierten Chip C3. Im Unterschied zu den Figuren 1 und 2 sind die hier mit IA3 bezeichneten Innenanschlüsse durch zusätzlich beim Spritzgießen des Substrats S im Bodenbereich der Mulde M3 mitgeformte und mit einer lötbaren Endoberfläche versehene Polymerhöcker PH gebildet. Die Polymerhöcker PH für die Innenanschlüsse IA3 weisen etwa ein Drittel des Volumens der Polymerhöcker PS für die Außenanschlüsse AA auf. Der in Face down-Lage in der Mulde M3 angeordnete Chip C3, liegt mit seinen Chipanschlüssen CA3 auf den zugeordneten Innenanschlüssen IA3 der Polymerhöcker PH auf und wird mit diesen durch Löten verbunden. Das hier nicht dargestellte Lot kann beispielsweise in Form einer im Kuppenbereich auf die Innenanschlüsse IA3 aufgebrachten Lotschicht bereitgestellt werden, in gleicher Weise, wie bei den Außenanschlüssen AA.

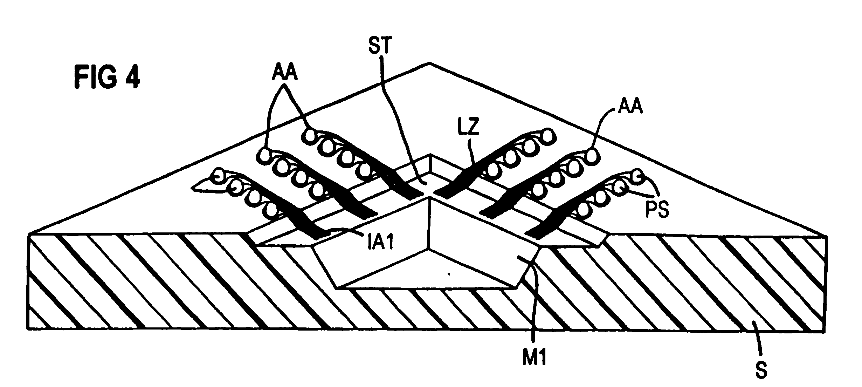

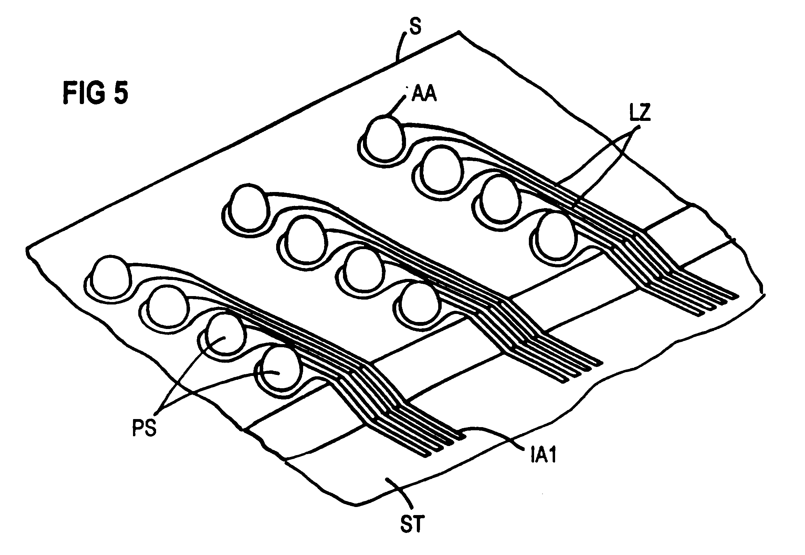

Die Figuren 4 und 5 zeigen Einzelheiten des in Figur 1 dargestellten Polymer Stud Grid Arrays, wobei das Substrat S hier jedoch vor der Befestigung des Chips C1 in der Mulde M1 dargestellt wurde. Es ist zu erkennen, daß die auf den Polymerhöckern PS gebildeten Außenanschlüsse AA reihenweise in einem feinen Raster angeordnet werden können. Die bei der MID Technologie übliche Laserfeinstrukturierung ermöglicht auch eine eng nebeneinanderliegende Anordnung der Leiterzüge LZ und der auf der Stufe ST liegenden Innenanschlüsse IA1.

Die vorstehend anhand der Figuren 1 bis 5 erläuterten Ausführungsbeispiele zeigen das Prinzip eines Polymer Stud Grid Arrays mit auf Polymerhöckern gebildeten Außenanschlüssen. Abweichend von der in der Zeichnung dargestellten Form können die Polymerhöcker auch andere Formen, wie z.B. eine Kegelstumpfform aufweisen. Obwohl jeweils nur ein Chip dargestellt wurde, kann die neue Bauform bei Single-, Few- oder Multi-Chip-Modulen angewandt werden. Die Chips können auch beispielsweise durch Ausgießen der Mulden oder durch die Anbringung von Deckeln verkapselt werden. Auf der Oberseite und den seitlichen Flächen des spritzgegossenen Substrats kann auch eine Metallisierungsschicht als elektromagnetische Abschirmung oder für eine gute Wärmeabfuhr verbleiben. Es ist jedoch auch möglich, das Substrat mit Durchkontaktierungen zu versehen, und auf der Oberseite eine zweite Verdrahtungslage anzuordnen. Auf dieser zweite Verdrahtungslage können nach dem Aufbringen entsprechender Dielektrikumsschichten auch weitere Leiterebenen nach Art einer Mehrlagenverdrahtung gebildet werden. Bei einem mit Durchkontaktierungen versehenen Substrat, können die Polymerhöcker und der Chip oder die Chips durchaus auch auf verschiedenen Seiten des Substrats angeordnet sein. Eine derartige Anordnung von Polymerhöckern und Chips auf gegenüberliegenden Seiten des Substrats ist insbesondere bei großen Chips, die eine Vielzahl von zugeordneten Außenanschlüssen benötigen, interessant.

## Patentansprüche

1. Polymer Stud Grid Array Package mit
- einem spritzgegossenen, dreidimensionalen Substrat (S) aus einem elektrisch isolierenden Polymer,
- auf der Unterseite des Substrats (S) beim Spritzgießen mitgeformten Polymerhöckern (PS),
- auf den Polymerhöckern (PS) durch eine lötbare Endoberfläche gebildeten Außenanschlüssen (AA),
- zumindest auf der Unterseite des Substrats (S) ausgebildeten Leiterzügen (LZ), welche die Außenanschlüsse (AA) mit Innenanschlüssen (IA1;IA2;IA3) verbinden, und mit
- mindestens einem auf dem Substrat (S) angeordneten Chip (C1;C2;C3), dessen Anschlüsse (CA1;CA2;CA3) mit den Innenanschlüssen (IA1;IA2;IA3) elektrisch leitend verbunden sind, wobei
- die Polymerhöcker (PS) die auf der Unterseite des Substrats (5) flächig im Grid Array angeordneten Polymer Studs bilden.

2. Polymer Stud Grid Array Package nach Anspruch 1,
**dadurch gekennzeichnet,**
daß der Chip (C1;C2;C3) in einer Mulde (M1;M2;M3) des Substrats (S) angeordnet ist.

3. Polymer Stud Grid Array Package nach Anspruch 2,
**dadurch gekennzeichnet,**
daß der Chip (C1) in Face up-Lage in der Mulde (M1) angeordnet ist, und daß die Anschlüsse (CA1) des Chips (C1) über Kontaktierdrähte (KD) mit den zugeordneten Innenanschlüssen (IA1) elektrisch leitend verbunden sind.

4. Polymer Stud Grid Array Package nach Anspruch 3,
**dadurch gekennzeichnet,**
daß die Innenanschlüsse (IA1) auf einer Stufe (ST) der Mulde (M1) angeordnet sind.

5. Polymer Stud Grid Array Package nach Anspruch 2,
**dadurch gekennzeichnet,**
daß der Chip (C2;C3) in Face down-Lage in der Mulde (M2;M3) angeordnet ist, und daß die Anschlüsse (CA2;CA3) des Chips (C2;C3) mittels Flipchip-Kontaktierung mit den am Boden der Mulde (M2;M3) angeordneten Innenanschlüssen (IA2;IA3) elektrisch leitend verbunden sind.

6. Polymer Stud Grid Array Package nach Anspruch 5,
**dadurch gekennzeichnet,**
daß die Anschlüsse (CA2) des Chips (C2) als schmelzfähige Höcker ausgebildet sind.

7. Polymer Stud Grid Array Package nach Anspruch 5,
**dadurch gekennzeichnet,**
daß die Innenanschlüsse (IA3) durch zusätzliche beim Spritzgießen des Substrats (S) mitgeformte und mit einer lötbaren Endoberfläche versehene Polymerhöcker (PH) gebildet sind.

## Claims

1. Polymer stud grid array package having
- an injection-moulded, three-dimensional substrate (S) composed of an electrically insulating polymer,
- polymer studs (PS) which are also formed during the injection-moulding process on the underneath of the substrate (S),
- external connections (AA) which are formed on the polymer studs (PS) by means of an end surface which can be soldered,
- conductor runs (LZ) which are formed at least on the underneath of the substrate (S) and connect the external connections (AA) to internal connections (IA1; IA2; IA3) and having
- at least one chip (C1; C2; C3) which is arranged on the substrate (S) and whose connections (CA1; CA2; CA3) are electrically conductively connected to the internal connections (IA1; IA2; IA3), in which case
- the polymer studs (PS) 'are planarly arranged in the grid array on the underneath of the substrate (S).

2. Polymer stud grid array package according to Claim 1, characterized in that the chip (C1; C2; C3) is arranged in a trough (M1; M2; M3) in the substrate (S).

3. Polymer stud grid array package according to Claim 2, characterized in that the chip (C1) is arranged in the face-up position in the trough (M1), and in that the connections (CA1) of the chip (C1) are electrically conductively connected via contact-making wires (KD) to the associated internal connections (IA1).

4. Polymer stud grid array package according to Claim 3, characterized in that the internal connections (IA1) are arranged on a step (ST) in the trough (M1).

5. Polymer stud grid array package according to Claim 2, characterized in that the chip (C2; C3) is arranged in the face-down position in the trough (M2; M3), and in that the connections (CA2; CA3) of the chip (C2; C3) are electrically conductively connected by means of flipchip contact-making to the internal connections (IA2; IA3) which are arranged on the bottom of the trough (M2; M3).

6. Polymer stud grid array package according to Claim 5, characterized in that the connections (CA2) of the chip (C2) are designed in the form of studs which can melt.

7. Polymer stud grid array package according to Claim 5, characterized in that the internal connections (IA3) are formed by additional polymer studs (PH) which are also formed during the injection-moulding of the substrate (S) and are provided with an end surface which can be soldered.

## Revendications

1. Boîtier PSGA (Polymer Stud Grid Array), comprenant
- un substrat (S) tridimensionnel moulé par injection, constitué d'un polymère électriquement isolant,
- sur le dessous du substrat (S), des bosses (PS) en polymère conjointement formées lors du moulage par injection,
- des bornes (AA) extérieures, formées sur les bosses (PS) en polymère par une surface terminale pouvant être brasée,
- des tracés (LZ) conducteurs formés au moins sur le dessous du substrat (S), qui relient les bornes (AA) extérieures à des bornes (IA1 ; IA2 ; IA3) intérieures, et comprenant
- au moins une puce (C1 ; C2 ; C3) disposée sur le substrat (S), puce dont les connexions (CA1 ; CA2 ; CA3) sont reliées en conduction électrique aux bornes (IA1 ; IA2 ; IA3) intérieures,
- les bosses (PS) en polymère formant les projections en polymère (Polymer Studs) disposées en nappe dans le réseau de trame (Grid Array).

2. Boîtier PSGA suivant la revendication 1, **caractérisé** en ce que la puce (C1) est disposée dans une cuvette (M1 ; M2 ; M3) du substrat (S).

3. Boîtier PSGA suivant la revendication 2, **caractérisé** en ce que la puce (C1) est disposée en position face en haut (face up) dans la cuvette (M1), et en ce que les bornes (CA1) de la puce (C1) sont reliées en conduction électrique au moyen de fils (KD) de contact métalliques aux bornes (IA1) intérieures associées.

4. Boîtier PSGA suivant la revendication 3, **caractérisé** en ce que les bornes (IA1) intérieures sont disposées sur un gradin (ST) de la cuvette (M1).

5. Boîtier PSGA suivant la revendication 2, **caractérisé** en ce que la puce (C2 ; C3) est disposée en position face en bas (face down) dans la cuvette (M2 ; M3), et en ce que les bornes (CA2 ; CA3) de la puce (C2 ; C3) sont reliées en conduction électrique au moyen d'une mise en contact par plots (flip chip) aux bornes (IA2 ; IA3) intérieures, disposées sur le fond de la cuvette (M2 ; M3).

6. Boîtier PSGA suivant la revendication 5, **caractérisé** en ce que les bornes (CA2) de la puce (C2) sont réalisées sous forme de bosses fusibles.

7. Boîtier PSGA suivant la revendication 5, **caractérisé** en ce que les bornes (IA3) intérieures sont formées par des bosses (PH) en polymère supplémentaires, conjointement formées lors du moulage par injection du substrat (S) et pourvues d'une surface terminale pouvant être brasée.
